# EUROPÄISCHE PATENTSCHRIFT

(11) **EP 3 803 913 B1**
(45) Veröffentlichungstag und Bekanntmachung des Hinweises auf die Patenterteilung: **17.07.2024**
(21) Anmeldenummer: 19722883.6
(22) Anmeldetag: 07.05.2019
(51) Int. Cl.: H01F 1/03, H01F 10/193

(54) **VERFAHREN ZUR REKONFIGURATION EINER VORTEX-DICHTE IN EINEM SELTENEN-ERD-MANGANAT, EIN NICHTFLÜCHTIGER IMPEDANZSCHALTER UND DESSEN VERWENDUNG**
METHOD FOR THE RECONFIGURATION OF A VORTEX DENSITY IN A RARE EARTH MANGANATE, A NON-VOLATILE IMPEDANCE SWITCH AND USE THEREOF
PROCÉDÉ DE RECONFIGURATION D'UNE DENSITÉ DE VORTEX DANS UN MANGANATE DE TERRES RARES, COMMUTATEUR À IMPÉDANCE NON VOLATIL ET UTILISATION DE CELUI-CI

(30) Priorität: 25.05.2018 DE 102018112605
(43) Veröffentlichungstag der Anmeldung: 14.04.2021
(73) Patentinhaber: Helmholtz-Zentrum Dresden - Rossendorf e.V., 01328 Dresden (DE)
(72) Erfinder: SCHMIDT, Heidemarie, 01069 Dresden (DE); DU, Nan, 07745 Jena (DE); BOGUSZ, Agnieszka, 01159 Dresden (DE); KRÜGER, Stephan, 01109 Dresden (DE); SKORUPA, Ilona, 01108 Dresden (DE)
(74) Vertreter: Lippert Stachow Patentanwälte Rechtsanwälte Partnerschaft mbB
(86) Internationale Anmeldenummer: PCT/EP2019/061717
(87) Internationale Veröffentlichungsnummer: WO 2019/223999

(56) Entgegenhaltungen:
- BOGUSZ A ET AL: "Resistive switching in polycrystalline YMnO3thin films", AIP ADVANCES, AMERICAN INSTITUTE OF PHYSICS, 2 HUNTINGTON QUADRANGLE, MELVILLE, NY 11747, vol. 4, no. 10, 20 October 2014 (2014-10-20), XP012191088, DOI: 10.1063/1.4899188
- YAN Z ET AL: "Unipolar resistive switching effect in YMn1-[delta]O3 thin films", APPLIED PHYSICS LETTERS, A I P PUBLISHING LLC, US, vol. 96, no. 1, 5 January 2010 (2010-01-05), pages 12103 - 12103, XP012130241, ISSN: 0003-6951, DOI: 10.1063/1.3280380
- MEIER Q N ET AL: "Global formation of topological defects in the multiferroic hexagonal manganites", ARXIV.ORG, CORNELL UNIVERSITY LIBRARY, 201 OLIN LIBRARY CORNELL UNIVERSITY ITHACA, NY 14853, 24 March 2017 (2017-03-24), XP081274820, DOI: 10.1103/PHYSREVX.7.041014
- E. RUFF ET AL: "Conductivity Contrast and Tunneling Charge Transport in the Vortexlike Ferroelectric Domain Patterns of Multiferroic Hexagonal YMnO3", PHYSICAL REVIEW LETTERS, vol. 118, no. 3, 1 January 2017 (2017-01-01), US, XP055619153, ISSN: 0031-9007, DOI: 10.1103/PhysRevLett.118.036803

## Beschreibung

Die Erfindung betrifft ein Verfahren zur Rekonfiguration einer Vortex-Dichte in einem Seltene-Erd-Manganat.

Die Erfindung betrifft weiterhin einen nichtflüchtigen Impedanzschalter mit rekonfigurierbarer Impedanz.

Die Erfindung betrifft auch die Verwendung des nichtflüchtigen Impedanzschalters als diskretes Bauelement oder als durchstimmbares Filter.

Im Stand der Technik sind Hybridmaterialien aus metallisch leitenden Pfaden in einem Dielektrikum bekannt [Radio Frequency Integrated Circuits and Technologies, Frank Ellinger, Springer-Verlag Berlin Heidelberg, 2008], deren Impedanzeigenschaften über die Geometrie und Volumeneigenschaften der Metalle und Dielektrika bei der Herstellung vorgegeben sind. Die Metalle werden in Form von metallisch leitenden Pfaden in ein Dielektrikum eingebracht, woraus sich der Begriff Hybridmaterial ableitet, da diese Konfiguration aus mindestens zwei Materialien mit verschiedenen elektrischen Leitfähigkeitseigenschaften besteht. Werden solche Hybridmaterialien in elektronischen Schaltungen eingesetzt, dann müssen sie im Arbeitsfrequenzbereich einen Gütefaktor von typischerweise 1 bis 50 aufweisen [Radio Frequency Integrated Circuits and Technologies, Frank Ellinger, Springer-Verlag Berlin Heidelberg, 2008]. Der Arbeitsfrequenzbereich von diskreten Bauelementen aus Hybridmaterialien mit metallisch leitenden Pfaden in einem Dielektrikum wird durch das Design und die Fertigung festgelegt. Die Impedanzeigenschaften der diskreten Bauelemente aus Hybridmaterialien mit metallisch leitenden Pfaden in einem Dielektrikum können nach der Herstellung nicht geändert werden. Um Impedanzeigenschaften, beispielsweise den Arbeitsfrequenzbereich, zu ändern, werden die diskreten Bauelemente aus diesen Hybridmaterialien mit metallisch leitenden Pfaden in einem Dielektrikum in einer elektronischen Schaltung mit weiteren diskreten Bauelementen eingesetzt, wobei immer eine Reduktion des Gütefaktors der elektronischen Schaltung im Bereich der Arbeitsfrequenz des diskreten Bauelementes aus Hybridmaterialien mit metallisch leitenden Pfaden in einem Dielektrikum beobachtet wird.

Sowohl in Bogusz, A. et al. "Resistive switching in polycristalline YMnOs thin films", AIP ADVANCES, AMERICAN INSITUTE OF PHYSICS, DOI:10.1063/1.4899188 als auch in Yan, Z. et al. "Unipolar resistive switching effect in YMm-sOs thin films", APPLIED PHYSICS LETTERS, DOI:10.1063/1.3280380 werden unipolare resistive Schalteigenschaften von YMn_{1-δ}O₃-Dünnschichten untersucht, wobei das Seltene-Erd-Manganat zwischen zwei Kontakten angeordnet ist.

Des Weiteren stellen im Stand der Technik Induktivitäten von nH bis µH aufgrund des um mehrere Größenordnungen größeren Footprints von >10⁶-10⁷ µm² ein Hindernis für die Realisierung kleiner, hochintegrierter und energieeffizienter Spannungswandler dar.

Hochkompakte und energieeffiziente Spannungsversorgungen sind eine Grundvoraussetzung für leistungsfähige mikroelektronische Systeme. Beispielsweise benötigen Fahrerassistenzsysteme zur Datenauswertung heterogene Mikrocontroller- und Prozessorstrukturen mit steigender Anzahl an unterschiedlichen Prozessorkernen. Der damit verbundene steigende Leistungsverbrauch benötigt ein hochkomplexes Power Management mit parallelisierten, mehrphasigen Spannungswandlern. Die in jeder Phase zum Einsatz kommenden Spulen dominieren aufgrund ihres großen Footprints immer noch die Baugröße und oft auch den Wirkungsgrad der Mikrocontroller- und Prozessorstrukturen. Der Footprint bezeichnet die physischen Abmessungen der Induktivität beispielsweise auf einem Substrat einer elektronischen Schaltung. Verkleinerte induktive Bauelemente würden kompakter und energieeffizienter sein und einen geringeren Verdrahtungsaufwand aufweisen.

Aus dem Stand der Technik bekannte induktive Bauelemente sind beispielsweise planare Induktivitäten mit magnetischem Kern auf einem separaten Si-Interposer, Luftkernspulen lagenweise als Teil des Gehäuses, laterale Spiralspulen aus den oberen Metallisierungsebenen direkt auf dem IC und Magnetkernspulen direkt auf dem IC unter Verwendung der oberen Metalllagen. Durch Verwendung von Through-Silicon-Vias (TSV) wird ein Footprint von 111nH/mm² mit Wirkungsgraden um 75% erreicht.

Aus dem Stand der Technik sind des Weiteren sogenannte YIGbasierte Bauelemente bekannt, die in GHz-Filter oder GHz-Resonatoren zum Einsatz kommen. Yttrium-Eisengranat, kurz YIG, ist ein künstlich hergestellter Granat der Zusammensetzung Y₃Fe₂(FeO₄)₃ oder Y₃Fe₅O₁₂. YIG ist ein ferrimagnetischer Isolator, die Curie-Temperatur liegt bei 550 K. YIG zeigt einen starken Faraday-Effekt, d.h. einen magnetooptischen Effekt, der die Drehung der Polarisationsebene einer linear polarisierten elektromagnetischen Welle in einem Medium beschreibt, wenn darin ein Magnetfeld parallel zur Ausbreitungsrichtung der Welle herrscht. YIG hat eine hohe Güte im Mikrowellenbereich und eine sehr kleine Linienbreite in der Elektronenspinresonanz. Deshalb ist dieses Material geeignet, in Mikrowellen-, optischen und magnetooptischen Anwendungen eingesetzt zu werden, z.B. als frequenzbestimmendes Element im Resonator von YIG-Oszillatoren und in YIG-Filtern für Frequenzen im Gigahertz-Bereich.

Wird der Yttrium-Eisengranat als YIG-Resonator eingesetzt, kann er die Form einer kleinen Kugel mit einem Durchmesser in der Größenordnung von wenigen mm haben. Zum Abstimmen der Resonanzfrequenz wird ein externes Magnetfeld H₀ verwendet. Die Resonanzfrequenz von YIG-Filtern liegt zwischen f₀ = 0,5...100 GHz und die Resonatorgüte beträgt etwa 10⁴, da YIG eine sehr geringe Dämpfungskonstante hat. Nachteilig ist allerdings, dass der YIG-Filter auf Temperaturänderungen sehr empfindlich reagiert. Deswegen muss die komplette Anordnung im Betrieb beheizt und über einen Regler auf einer konstanten Betriebstemperatur von 85°C gehalten werden. Die Resonanzfrequenz ist proportional zum angelegten Feld. Der Abstimmbereich der Resonanzfrequenz von YIG-basierten Bauelementen ist nach oben hin im Wesentlichen durch das erzeugbare Magnetfeld H₀ beschränkt. Die untere Grenzfrequenz ergibt sich aus der Bedingung, dass das interne Magnetfeld positiv ist und beträgt für eine Kugelform etwa 1,67 GHz. Ein weiterer wesentlicher Nachteil ist die Durchstimmbarkeit der Resonanzfrequenz durch ein externes Magnetfeld, weil die Anordnung zur Erzeugung des externen Magnetfeldes nicht bis auf die Größe des YIG-basierten Bauelementes miniaturisiert werden kann und gegebenenfalls eine magnetische Abschirmung des YIG-basierten Bauelementes zusammen mit der Anordnung zur Erzeugung des externen Magnetfeldes zum Schutz weiterer Bauelemente nötig ist.

Es ist daher die Aufgabe der vorliegenden Erfindung zunächst ein Verfahren anzugeben, mittels dem in speziellen Materialien deren Impedanz in Abhängigkeit von einer Vortex-Dichte ohne großen Aufwand beeinflusst und eingestellt werden kann. Es ist weiterhin eine Aufgabe der Erfindung einen Impedanzschalter anzugeben, der nichtflüchtig rekonfigurierbar ist und in durchstimmbaren Filtern und Resonatoren eingesetzt werden kann, wobei die Nachteile der bekannten diskreten Bauelemente aus Hybridmaterialien mit metallisch leitenden Pfaden in einem Dielektrikum sowie der YIG-Bauelemente vermieden werden sollen.

Eine weitere Aufgabe ist es, Mikroinduktivitäten mit einem geringen Footprint (Flächenbedarf der Mikroinduktivität) zu realisieren. Dazu wird eine hohe Vortexdichte im Impedanzschalter realisiert. Beispielsweise kann die Induktivitätsdichte Footprint von derzeit 100nH/mm² bei Verwendung einer Elektrodenfläche am Impedanzschalter von 200 um x 200 um um mindestens den Faktor zehn gesteigert werden.

Die Aufgabe wird durch ein Verfahren gemäß den unabhängigen Verfahrensansprüchen 1 und 2 gelöst.

In dem Verfahren zur Rekonfiguration einer Vortex-Dichte in einem Seltene-Erd-Manganat wird ein einmaliges Spannungs-Zeit-Profil zwischen einem ersten und einem zweiten, an das Seltene-Erd-Manganat angebrachten elektrisch leitenden Kontakt angelegt, so dass das Seltene-Erd-Manganat in einem Bereich eines sich zwischen den beiden elektrisch leitenden Kontakten ausbildenden elektrischen Feldes während eines Abkühlvorganges während und nach Anlegen des einmaliges Spannungs-Zeit-Profils eine Ordnungstemperatur durchläuft und damit die Vortex-Dichte lokal im Bereich des sich zwischen den beiden elektrisch leitenden Kontakten ausbildenden elektrischen Feldes beeinflusst und eingestellt wird.

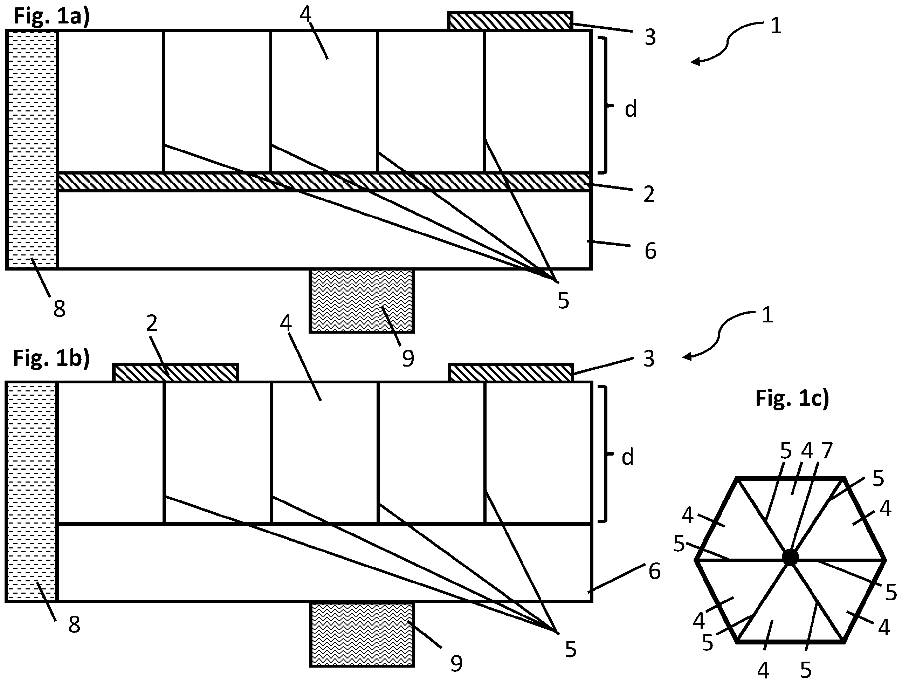

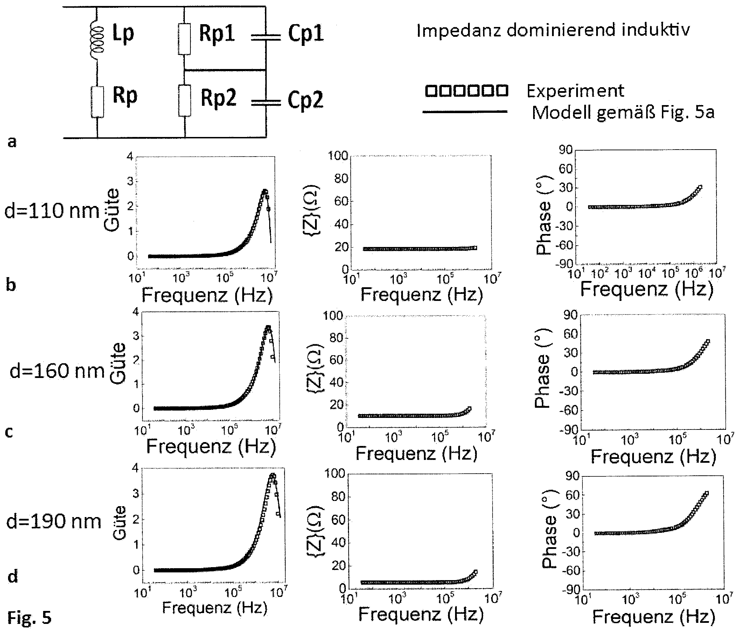

Unter einem Seltene-Erd-Manganat im Sinne dieser Erfindung werden solche Materialien verstanden, die bei Anlegen einer Spannung oder dem Durchlaufen eines Heiz- und/oder Abkühlungsprozesses Vortex-Zustände ausbilden. Ein Vortex-Zustand kann als ein Schnittpunkt zwischen geladenen Domänenwänden innerhalb eines Materials verstanden werden. Vortex-Zustände konnten bereits mittels Transmission Scanning Electron Microscopy an Einkristallen hexagonaler Seltene-Erd-Manganate (RMnOs, R=Ho..Lu und Sc) (Abb. 1c in Direct Observation of Multiferroic Vortex Domains in YMnOs Qinghua Zhang, Guotai Tan, Lin Gu, Yuan Yao, Changqing Jin, Yanguo Wang, Xiaofeng Duan, Richeng Yu, SCIENTIFIC REPORTS | 3 : 2741 | DOI: 10.1038/srep02741) beobachtet werden. In diesen hexagonalen Seltene-Erd-Manganaten bilden sich Vortex-Zustände im Zentrum von sechs verschiedenen ferroelektrischen Domänenwänden (DW), zwei geladene DW (head-to-head), zwei geladene DW (tail-to-tail) und zwei neutrale DW (head-to-tail) aus. Ein Vortex-Zustand ist topologisch geschützt, d.h. er lässt sich nicht durch kontinuierliche Transformation in den Grundzustand überführen. Die ferroelektrische Ordnungstemperatur T_{c} der hexagonalen Seltene-Erd-Manganate RMnO hängt von dem Seltene-Erd-Element in RMnO ab. Oberhalb einer Temperatur von T_{c} bildet sich keine ferroelektrische Ordnung mit ferroelektrischen Domänenwänden und geladenen Vortex-Zuständen aus. Beispielsweise beträgt die ferroelektrische Ordnungstemperatur für HoMnOs T_{c} = 875 K, für LuMnOs T_{c} = 573 K und für YMnOs T_{c} = 930 K. Beim Erhitzen der hexagonalen Seltene-Erd-Manganate RMnOs über die ferroelektrische Ordnungstemperatur hinaus, ist die ferroelektrische Ordnung nicht ausgeprägt. Die Vortex-Dichte beim nachfolgenden Abkühlen der hexagonalen Seltene-Erd-Manganate hängt von der Abkühlrate zum Zeitpunkt des Abkühlvorganges ab, bei dem die Abkühltemperatur gleich der ferroelektrischen Ordnungstemperatur ist. So wurden Vortex-Dichten von 0,01 Vortices/m² bei einer Abkühlrate von 10⁻³ K/min und von 1,00 Vortices/m² bei einer Abkühlrate von 1 K/min in YMnOs-Einkristallen erreicht (Fig. 5 in From multiferroics to cosmology: Scaling behaviour and beyond in the hexagonal manganites, S. M. Griffin, M. Lilienblum, K. Delaney, Y. Kumagai, M. Fiebig, N. A. Spaldin, Phys. Rev. X 2, 041022, 2012]). Unterhalb der ferroelektrischen Ordnungstemperatur hängt die Dichte der Vortices von der Abkühlrate ab. Wird eine Spannung mit einer vorgegebenen Amplitude und für eine vorgegebene Zeitdauer an die mindestens zwei Kontakte, welche an einem Seltene-Erd-Manganat befestigt sind, angelegt, fließt ein Strom zwischen den beiden Kontakten.

Aufgrund des elektrischen Widerstandes das Seltene-Erd-Manganate wird ein Teil der elektrischen Energie in Joulesche Wärme umgewandelt und das Seltene-Erd-Manganat wird im Bereich zwischen den elektrisch leitenden Kontakten erwärmt. Ist der Eintrag der Jouleschen Wärme so groß, dass das Seltene-Erd-Manganat über die ferroelektrische Ordnungstemperatur hinaus erwärmt wird, ist die ferroelektrische Ordnung aufgehoben. Die ferroelektrische Ordnung stellt sich beim Abkühlen der Seltene-Erd-Manganate wieder ein, sobald die Temperatur des Seltene-Erd-Manganats kleiner als die ferroelektrische Ordnungstemperatur ist. Die Vortex-Dichte hängt von der Abkühlrate beim Durchlaufen der ferroelektrischen Ordnungstemperatur ab.

Erfindungsgemäß wird an einem Seltene-Erd-Manganat eine Spannung mit einem definierten Spannungs-Zeit-Profil zwischen dem ersten und zweiten Kontakt des Seltene-Erd-Manganats angelegt. Die Spannung wird mit einer vorgegebenen Amplitude und für eine vorgegebene Zeitdauer an die Kontakte angelegt, so dass sich ein elektrisches Feld ausbildet und es zu einem Stromfluss kommt. Der Stromfluss bewirkt, dass das Seltene-Erd-Manganat durch Joulesche Wärme über die für das Material charakteristische Ordnungstemperatur erwärmt wird, so dass vorhandene Domänenwände und Vortices aufgebrochen werden. Durch die zeitliche Begrenzung der angelegten Spannung, gemäß dem gewählten Spannungs-Zeit-Profil und der Kontrolle des Heiz- und Abkühlprozesses über Abkühl- und Heizelemente (Isolationsstrukturen) wird nach Abschaltung der Spannung ein Abkühlungsprozess in Gang gesetzt, dessen Temperaturgradient einerseits durch das verwendete Spannungs-Zeit-Profil und anderseits durch Isolationsstrukturen, in welche das Seltene-Erd-Manganat eingebettet ist, beeinflusst und eingestellt wird. Damit kann eine zeitlich gesteuerte Wärmeabfuhr realisiert werden. Das Profil der angelegten Spannung und der sich ausbildende Temperaturgradient haben den Effekt, dass sich bei einer folgenden Abkühlung des Materials, unter dessen charakteristische Ordnungstemperatur, die Vortex-Dichte beeinflussen lässt, die sich aufgrund des gesteuerten Abkühlungsprozesses mit einem bestimmten Temperaturgradienten derart ausbilden, dass das Seltene-Erd-Manganat ein induktives oder kapazitives Verhalten zeigt, je nachdem welches Verhalten konfiguriert werden soll.

Erfindungsgemäß ist das Spannungs-Zeit-Profil ein Spannungsimpuls oder eine Spannungsrampe. Ein Spannungsimpuls wird bevorzugt eingesetzt, wenn das Schalten zwischen einem Seltene-Erd-Manganat mit hoher oder niedriger Vortex-Dichte schnell und energieeffizient erfolgen soll. Ein Spannungs-Zeit-Profil in Form einer Spannungsrampe wird eingesetzt, wenn nicht bekannt ist, wie groß die Schwellspannungen U_{SET} und U_{RESET} sind, wobei es bei U_{SET} zu einem Umschalten des Seltene-Erd-Manganats aus einem Zustand mit hohem ohmschen Widerstand in einen Zustand mit geringem ohmschen Widerstand kommt und bei U_{RESET} wird das Seltene-Erd-Manganat von einem Zustand mit geringem ohmschen Widerstand in einen Zustand mit hohem ohmschen Widerstand umgeschaltet. Werden Spannungsimpulse mit Amplituden, welche wesentlich größer als U_{SET} und U_{RESET} sind, verwendet, dann kann aufgrund des hohen Eintrags an Joulescher Wärme das Seltene-Erd-Manganat im Bereich zwischen den beiden elektrisch leitenden Kontakten beschädigt werden.

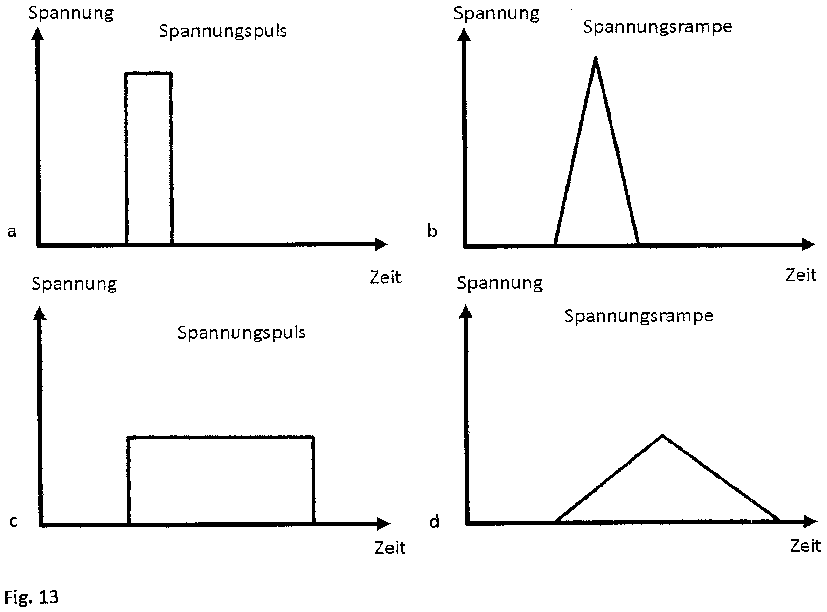

Ein Spannungsimpuls kann gegenüber einer Spannungsrampe (Abb. 13b, 13d) von Vorteil sein, da das Durchlaufen einer Spannungsrampe im Vergleich zu einem Spannungspuls (Abb. 13a, 13c) vergleichsweise lange dauert. Darüber hinaus kühlt sich das Seltene-Erd-Manganat während des Anlegens der Spannungsrampe zwischen den beiden elektrischen leitenden Kontakten teilweise wieder ab, so dass nur ein kleiner Anteil der eingetragenen elektrischen Energie in Joulesche Wärme umgewandelt wird. Mit den beiden veränderlichen Spannungsprofilen, beispielsweise mit einer Spannungsrampe und/oder mit einem Spannungspuls erreicht man zwei verschiedene Abkühlraten beim Durchlaufen der ferroelektrischen Ordnungstemperatur während des Abkühlvorganges. Die kleinere der beiden Abkühlraten (Spannungsrampe) verursacht die Ausprägung einer kleinen Vortex-Dichte und die größere der beiden Abkühlraten (Spannungspuls) verursacht die Ausprägung einer großen Vortex-Dichte im Seltene-Erd-Manganat zwischen den beiden elektrisch leitenden Kontakten.

Erfindungsgemäß wird für die Rekonfiguration der Vortex-Dichte mit einer resultierenden Impedanz mit dominierend induktivem Blindwiderstand ein Temperaturgradient größer als 1 K/min, bevorzugt größer als 10 K/min, noch bevorzugter größer als 100 K/min erzeugt. Zur Rekonfiguration der Vortex-Dichte mit einer resultierenden Impedanz mit dominierend induktivem Blindwiderstand ((Induktivität L, Z = R_{ON} + jwL) wird ein langer Spannungspuls mit großer Amplitude oder eine schnelle Spannungsrampe großer Amplitude an die kontaktierte Schichtabfolge angelegt. Dadurch bilden sich geladene Domänenwände mit einer hohen Dichte aus.

Erfindungsgemäß wird für die Rekonfiguration der Vortex-Dichte mit einer resultierenden Impedanz mit dominierend kapazitivem Blindwiderstand ein Temperaturgradient kleiner als 100K/min, bevorzugt kleiner als 10 K/min, noch bevorzugter kleiner als 1 K/min erzeugt. Zur Rekonfiguration der Vortex-Dichte mit einer resultierenden Impedanz mit dominierend kapazitivem Blindwiderstand (Kapazität C, Z = R_{OFF} - j1/(wC)) wird ein kurzer Spannungspuls geringer Amplitude oder eine langsame Spannungsrampe geringer Amplitude an die kontaktierte Schichtabfolge angelegt. R_{OFF} ist größer als R_{ON}. Der Wert der Kapazität C hängt von der Fläche A des mindestens einen Kontaktes und von der Dicke des Seltene-Erd-Manganats ab, d.h. eine kleine Kontaktfläche bewirkt eine kleine Kapazität; eine geringe Dicke des Seltene-Erd-Manganats bewirkt eine große Kapazität.

Die Aufgabe wird auch, gemäß dem unabhängigen Anspruch 3, durch einen nichtflüchtigen Impedanzschalter, rekonfiguriert nach dem erfindungsgemäßen Verfahren zur Rekonfiguration einer Vortex-Dichte, gelöst, umfassend eine Schichtabfolge bestehend aus mindestens einer Schicht aus einem Seltenen-Erd-Manganat sowie einen ersten Kontakt, der auf einer Seite des Seltenen-Erd-Manganats angeordnet ist sowie einen zweiten Kontakt, der auf der gegenüberliegenden Seite des ersten Kontaktes oder auf der gleichen Seite wie der erste Kontakt angeordnet ist sowie Isolationsstrukturen zur zeitlich gesteuerten Wärmeabfuhr und zur Einstellung eines Temperaturgradienten während eines Durchlaufens einer Ordnungstemperatur des Seltene-Erd-Manganats.

Unter einem nichtflüchtigen Impedanzschalter wird im Sinne dieser Erfindung ein Bauelement verstanden, dessen Impedanzeigenschaften wiederholt geschaltet werden können. Die Impedanz, auch Wechselstromwiderstand genannt, ist ein elektrischer Widerstand in der Wechselstromtechnik. Sie gibt das Verhältnis von elektrischer Spannung zur Stromstärke an und kennzeichnet insbesondere eine Phasenverschiebung zwischen diesen beiden Größen. Die Impedanz hat z.B. Bedeutung bei der Anpassung von Hochfrequenzleitungen. Wenn zum Beispiel die Eingangsimpedanz eines Gerätes nicht mit der Impedanz der Leitung übereinstimmt, kommt es zu Reflexionen, was die Leistungsübertragung mindert und was zu Resonanzerscheinungen und damit zu einem nichtlinearen Frequenzgang führen kann. Die Impedanz, in kartesischen Koordinaten Z = R + jX, setzt sich aus einem Realteil R für den Wirkwiderstand und einem Imaginärteil für den Blindwiderstand X zusammen. In einem Verbraucher mit einer Induktivität L hat diese einen positiven (induktiven) Blindwiderstand; die Spannung eilt dem Strom vor. Dabei steht ω für die Kreisfrequenz der Schwingung. In einem Verbraucher mit einer Kapazität C hat diese hingegen einen negativen (kapazitiven) Blindwiderstand ; die Spannung eilt dem Strom nach.

Unter einer Schicht aus einem Seltene-Erd-Manganat, welche geladene Domänenwände aufweist, wird ein Material oder werden Materialien verstanden, die unterhalb der ferroelektrischen Ordnungstemperatur T_{c} des Seltene-Erd-Manganats sogenannte Vortex-Zustände ausbilden. Oberhalb der ferroelektrischen Ordnungstemperatur bildet sich keine ferroelektrische Ordnung mit ferroelektrischen Domänenwänden und geladenen Vortex-Zuständen aus. Beispielsweise beträgt die ferroelektrische Ordnungstemperatur für HoMnOs T_{c} = 875 K, für LuMnOs T_{c} = 573 K und für YMnOs T_{c} = 930 K. Beim Erhitzen der hexagonalen Seltene-Erd-Manganate RMnOs (R = Seltene-Erd-Element) über die ferroelektrische Ordnungstemperatur hinaus, ist die ferroelektrische Ordnung nicht ausgeprägt. Die Vortex-Dichte beim nachfolgenden Abkühlen der Seltene-Erd-Manganate hängt von der Abkühlrate zum Zeitpunkt des Abkühlvorganges ab, bei dem die Abkühltemperatur gleich der ferroelektrischen Ordnungstemperatur ist. Unterhalb der ferroelektrischen Ordnungstemperatur bilden sich Vortices aus. Die Vortex-Dichte hängt von der Abkühlrate des Seltene-Erd-Manganats beim Durchlaufen der ferroelektrischen Ordnungstemperatur T_{c} ab. Wird eine Spannung mit einer vorgegebenen Amplitude und für eine vorgegebene Zeitdauer an die mindestens zwei Kontakte, welche an einem Seltene-Erd-Manganat befestigt sind, angelegt, fließt ein Strom zwischen den beiden Kontakten. Aufgrund des elektrischen Widerstandes der Seltene-Erd-Manganate wird ein Teil der elektrischen Energie in Joulesche Wärme umgewandelt und das Seltene-Erd-Manganat wird erwärmt. Ist der Eintrag der Jouleschen Wärme so groß, dass das Seltene-Erd-Manganat über die ferroelektrische Ordnungstemperatur hinaus erwärmt wird, ist die ferroelektrische Ordnung aufgehoben. Die ferroelektrische Ordnung stellt sich beim Abkühlen der Seltene-Erd-Manganate wieder ein, sobald die Temperatur des Seltene-Erd-Manganats kleiner als die ferroelektrische Ordnungstemperatur ist. Durch die zeitliche Begrenzung der angelegten Spannung wird nach Abschaltung der Spannung ein Abkühlungsprozess in Gang gesetzt, dessen Temperaturgradient durch ein verwendetes Spannungs-Zeit-Profil beeinflusst und eingestellt werden kann. Der Temperaturgradient wird ebenfalls durch ausgebildete Isolationsstrukturen des erfindungsgemäßen nichtflüchtigen Impedanzschalters beeinflusst und eingestellt. Damit kann eine gesteuerte Wärmeabfuhr realisiert werden. Das Profil der angelegten Spannung und der sich ausbildende Temperaturgradient haben den Effekt, dass sich nach der Abschaltung der angelegten Spannung durch die folgende Abkühlung des Materials unter dessen charakteristische Ordnungstemperatur die Dichte der geladenen Domänenwände, d.h. Vortex-Dichte, beeinflussen lässt, die sich aufgrund des gesteuerten Abkühlungsprozesses mit einem bestimmten Temperaturgradienten derart ausbilden, dass der nichtflüchtige Impedanzschalter ein induktives oder kapazitives Verhalten zeigt, je nachdem welches Verhalten konfiguriert werden soll.

In einer Ausgestaltung des nichtflüchtigen Impedanzschalters ist mindestens einer der beiden Kontakte strukturiert ausgebildet. Durch das Anlegen einer Spannung an die zwei Kontakte bildet sich ein elektrisches Feld aus. Aufgrund des strukturierten Kontaktes kann die Vortex-Dichte lokal in einem definierten Bereich der mindestens einen Seltene-Erd-Manganat-Schicht definiert beeinflusst und eingestellt werden.

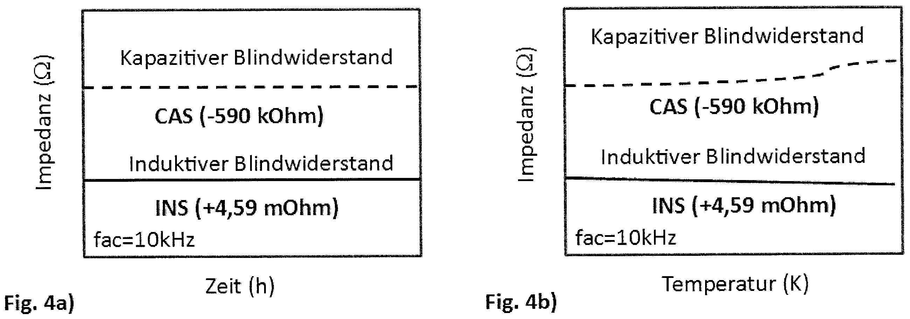

In einer bevorzugten Ausgestaltung des nichtflüchtigen Impedanzschalters ist das Seltene-Erd-Manganat das Material hexagonales YMnOs. Ein Vorteil durchstimmbarer Filter und Resonatoren auf der Basis von YMnOs-Impedanz-Bauelementen, im Vergleich zu anderen aus dem Stand der Technik bekannten durchstimmbaren Filtern und Resonatoren auf der Basis von YIG, ist die Nichtflüchtigkeit des Abstimmens der Resonanzfrequenz in einem YMnOs-basierten Filter und Resonator nach einmaligem Anlegen einer Spannung. Die Stabilität des Impedanz-Zustandes als Funktion der Zeit (Fig. 4a) und als Funktion der Temperatur (Fig. 4b) ist in Figur 4 gezeigt. Vorteilhaft ist darüber hinaus die Integrierbarkeit der YMnOs-basierten Bauelemente in einem BEOL-Prozess in CMOS-Technologie. Unter dem Back-End-of-Line (BEOL) Prozess wird der zweite Teil der IC-Fertigung verstanden, bei dem die einzelnen Bauelemente (Transistoren, Kondensatoren, Widerstände usw.) mit der Verdrahtung auf dem Wafer, der Metallisierungsschicht, verbunden werden. In einem BEOL-Prozess werden Kontakte, isolierende Schichten (Dielektrika), Metallebenen und Bondstellen für Chip-zu-Gehäuse-Verbindungen gefertigt.

In einer Ausgestaltung des erfindungsgemäßen nichtflüchtigen Impedanzschalters ist die Dicke der Schichtabfolge größer als 5 nm und kleiner als 5000 nm. Diese Grenzen sind vorteilhaft, weil die Vortex-Dichte in der Seltene-ErdSchicht zwischen der Vorder- und Rückseitenelektrode homogen sein soll, damit die von der Vortex-Dichte abhängigen Impedanzeigenschaften zwischen der Vorder- und Rückseitenelektrode homogen sind.

In einer weiteren besonders vorteilhaften Ausgestaltung des erfindungsmäßigen nichtflüchtigen Impedanzschalters weist der erste Kontakt und / oder zweite Kontakt eine Fläche von 10¹ bis 10⁵ µm² auf, vorzugsweise eine Fläche von 10¹ bis 10³ µm². Das hat den Vorteil, dass damit eine deutlich höhere Induktivitätsdichte realisierbar ist, als es bisher der Fall war. Die Realisierung kleiner, hochintegrierter und energieeffizienter Spannungswandler ist damit möglich.

Mit den bisher gezeigten Ausgestaltungen kann der Impedanzschalter zwischen einem induktiven und einem kapazitiven Seltene-Erd-Manganat geschalten werden. Diese beiden Impedanz-Zustände unterscheiden sich signifikant in ihrer komplexen Impedanz, in ihrer Güte, der Resonanzfrequenz und dem Phasenverlauf. Beispielsweise ist es für Phasenschieber vorteilhaft, wenn die Resonanzfrequenz und der Phasenverlauf durch Anlegen eines Spannungs-Zeit-profils beliebige Impedanzwerte annehmen kann.

Besonders vorteilhaft ist es, wenn der nichtflüchtige Impedanzschalter als diskretes Bauelement (gemäß dem Anspruch 8) in einer elektronischen Schaltung zur Anpassung einer Phasenverschiebung verwendet wird.

Auch vorteilhaft ist es, wenn der nichtflüchtige Impedanzschalter als durchstimmbares Filter (gemäß dem Anspruch 9) eingesetzt wird.

Besonders vorteilhaft ist es, wenn der nichtflüchtige Impedanzschalter als Zwei-Pin-Bauelement für diskrete passive Bauelemente (gemäß dem Anspruch 10) eingesetzt wird. Der Vorteil ist der kleine Footprint von 10³ bis 10⁵ µm² oder der noch kleinerer Footprint von 10¹ bis 10³ µm².

Ebenfalls besonders vorteilhaft ist es, wenn der nichtflüchtige Impedanzschalter als Flip-Chip zur Integration in Schaltungen für energieeffiziente Spannungswandler (gemäß dem Anspruch 11) eingesetzt wird.

Die Erfindung soll nachfolgend an Ausführungsbeispielen näher erläutert werden.

Die Zeichnungen zeigen
- Fig. 1: Beispielhafter nichtflüchtiger Impedanzschalter mit geladenen Domänenwänden (und Isolationsstrukturen) - unkonfiguriert (a) mit einer Elektrode an Vorderseite und einer Elektrode an Rückseite, (b)mit zwei Elektroden an Vorderseite , (c) Hexagonale Domänenstruktur mit Vortex im Zentrum;
- Fig. 2: a) Beispielhafter nichtflüchtiger Impedanzschalter mit geladenen Domänenwänden und niedriger Vortex-Dichte und dominierend kapazitivem Blindwiderstand, b) Beispielhafter nichtflüchtiger Impedanzschalter mit geladenen Domänenwänden und hoher Vortex-Dichte und dominierend induktivem Blindwiderstand;
- Fig. 3: Frequenzabhängiges Verhalten des konfigurierten Impedanzschalters;
- Fig. 4: Nachweise der Nichtflüchtigkeit des a) Blindwiderstandes des Impedanzschalters sowie b) dessen Temperaturstabilität;
- Fig. 5: Modellierung der gemessenen komplexen Impedanz Z mit dominierend induktivem Blindwiderstand;
- Fig. 6: Modellierung der gemessenen komplexen Impedanz Z mit dominierend kapazitivem Blindwiderstand;
- Fig. 7: Vergleich zwischen Modellierung und Messergebnissen für den Gütefaktor und die Resonanzfrequenz für Material im Low-Resistance-State (LRS) mit einer Dicke d = 110 nm und angeschlossenen externen Kapazitäten unterschiedlicher Werte;
- Fig. 8: Vergleich zwischen Modellierung und Messergebnissen für den Gütefaktor und die Resonanzfrequenz für Material im Low-Resistance-State (LRS) mit einer Dicke d = 160 nm und angeschlossenen externen Kapazitäten unterschiedlicher Größe;
- Fig. 9: Vergleich zwischen Modellierung und Messergebnissen für den Gütefaktor und die Resonanzfrequenz für Material im Low-Resistance-State (LRS) mit einer Dicke d = 190 nm und angeschlossenen externen Kapazitäten unterschiedlicher Größe;
- Fig. 10: Vergleich zwischen Modellierung und Messergebnissen für den Gütefaktor und die Resonanzfrequenz für Material im High-Resistance-State (HRS) mit einer Dicke d = 110 nm und angeschlossenen externen Induktivitäten unterschiedlicher Größe;
- Fig. 11: Vergleich zwischen Modellierung und Messergebnissen für den Gütefaktor und die Resonanzfrequenz für Material im High-Resistance-State (HRS) mit einer Dicke d = 160 nm und angeschlossenen externen Induktivitäten unterschiedlicher Größe;
- Fig. 12: Vergleich zwischen Modellierung und Messergebnissen für den Gütefaktor und die Resonanzfrequenz für Material im High-Resistance-State (HRS) mit einer Dicke d = 190 nm und angeschlossenen externen Induktivitäten unterschiedlicher Größe;
- Fig. 13: Spannungs-Zeit-Profile: a) kurzer Spannungspuls, b) kurze Spannungsrampe, c) langer Spannungspuls, d) lange Spannungsrampe.

Figur 1 zeigt den schematischen Aufbau des beispielhaften nichtflüchtigen Impedanzschalters 1 aus einem Seltene-Erd-Manganat 4 mit geladenen Domänenwänden 5 und Isolationsstrukturen 8. In einer möglichen Ausgestaltung ist mittels Dünnschichttechnologie auf einer Substratschicht 6 ein elektrisch leitender Rückseitenkontakt 2 auf die Schichtabfolge abgeschieden wurden. Die Gesamtdicke der Schichtabfolge in abstimmbaren elektrischen Resonatoren und Filtern sollte größer als 5 nm und kleiner als 5000 nm sein.

Abschließend wurde ein elektrisch leitender Vorderseitenkontakt 3 an der gegenüberliegenden Seite des Rückseitenkontaktes 2 angebracht. Der zweite Kontakt 3 kann auch auf der gleichen Seite wie der Rückseitenkontakt 2 an der Schichtabfolge 4 angebracht sein. Mindestens einer der beiden Kontakte 2, 3, d.h. entweder der Vorderseitenkontakt 3 und/oder der Rückseitenkontakt 2, ist strukturiert. Die Schichtabfolge 4 umfasst mindestens eine Schicht, welche geladene Domänenwände 5 aufweist. Diese Schicht ist ein Seltene-Erd-Manganat, beispielsweise YMnOs. Bei der Herstellung wird das Material typischerweise auf eine Substrattemperatur kleiner als die ferroelektrische Ordnungstemperatur erwärmt, wobei sich die Vortex 7-Dichte spontan einstellt.

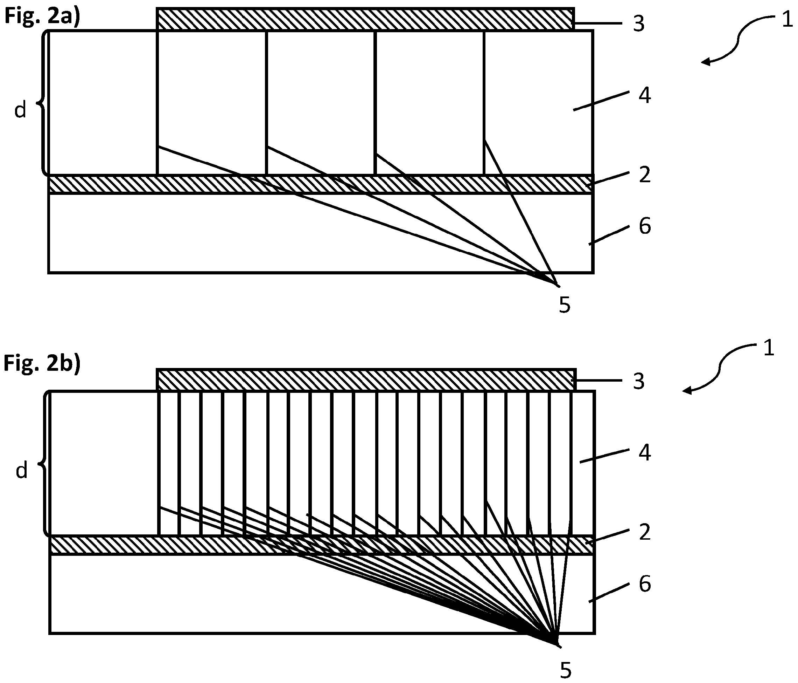

Figur 2a zeigt den beispielhaften nichtflüchtigen Impedanzschalter 1 mit geladenen Domänenwänden 5 geringer Vortex 7-Dichte und dominierend kapazitivem Blindwiderstand. Durch das Anlegen eines kurzen Spannungspulses mit großer Amplitude an die kontaktierte Schichtabfolge, bilden sich geladene Domänenwände 5 mit einer hohen Vortex 7-Dichte aus.

Figur 2b zeigt den beispielhaften nichtflüchtigen Impedanzschalter mit geladenen Domänenwänden 5 hoher Dichte und dominierend induktivem Blindwiderstand. Durch das Anlegen eines langen Spannungspulses geringer Amplitude an die kontaktierte Schichtabfolge, bilden sich geladene Domänenwände mit einer geringen Vortex 7-Dichte aus.

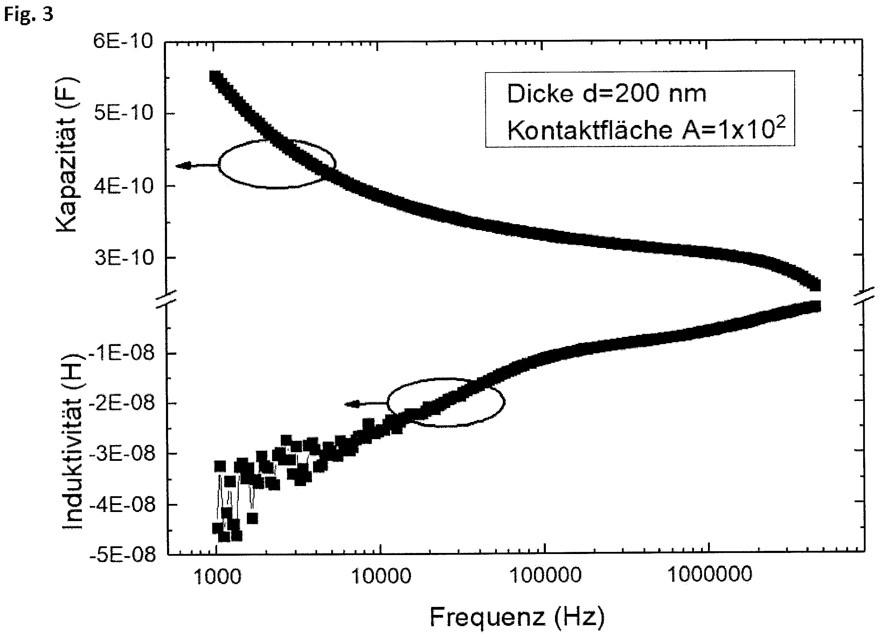

Figur 3 zeigt das frequenzabhängige Verhalten des konfigurierten Impedanzschalters 1 in einem Frequenzbereich von 1 kHz bis 40 MHz. Nach Anlegen der Schwellspannung U_{SET} schaltet der Widerstand der Seltene-Erd-Manganat-Dünnschicht von hoch (HRS-high-resistance-state) auf niedrig (LRS-low-resistance-state). Nach Anlegen der Schwellspannung U_{RESET} schaltet der Widerstand der Seltene-Erd-Manganat-Dünnschicht von niedrig (LRS) auf hoch (HRS).

In den Figuren 4a und 4b wird gezeigt, dass die Impedanz des erfindungsgemäßen Impedanzschalters 1 zeit- und temperaturunabhängig ist, d.h. das Impedanzverhalten kann nichtflüchtig eingestellt werden.

In Figur 5a ist ein Ersatzschaltbild des Materials mit geladenen Domänenwänden 5 zur Modellierung der gemessenen komplexen Impedanz Z mit dominierend induktivem Blindwiderstand abgebildet. Im Wesentlichen erfolgt die Modellierung durch eine Induktivität Lp in Reihe mit einem Widerstand Rp und parallel dazu zwei (Rp, Cp)-Paaren (Rp₁, Cp₁ und Rp₂, Cp₂). Die Impedanz und der Gütefaktor, wie sie in den Figuren 5b bis 5d abgebildet sind, wurden mit dem in Fig. 5a dargestellten Ersatzschaltbild modelliert. Die modellierten Werte der Parallel-Kapazität Cp₁ und Cp₂ sowie der Parallelwiderstände Rp₁ und Rp₂ nehmen mit der Dicke des Materials der mindestens einen Schicht ab. Die Induktivität Lp und der Gütefaktor Qₘₐₓ nehmen mit zunehmender Dicke zu. Die gemessenen und modellierten Gütefaktoren und Impedanzdaten sind für das Material mit einer Dicke von d = 110 nm (Fig. 5b), d = 160 nm (Fig. 5c) und d = 190 nm (Fig. 5d) gezeigt.

Die Tabelle 1 zeigt die modellierten Werte des Ersatzschaltbildes des Materials mit einer Dicke von d = 110 nm, 160 nm und 190 nm im LRS mit geladenen Domänenwänden, gemäß Figur 5.

**Tab.1: Modellierung der Impedanz und des Gütefaktors in Figur 5.**

| LRS | | YMO 110nm | YMO 160nm | YMO 190nm |
|---|---|---|---|---|
| Impedanz -modelliert | Cp₁ | 240 pF | 182 pF | 145 pF |
| | Rp₁ | 750 Ω | 308.6 Ω | 176 Q |
| | Cp₂ | 270 pF | 201 pF | 118 pF |
| | Rp₂ | 275.1 Ω | 250 Ω | 185 Ω |
| | RLp | 17 .85Ω | 9.51 Ω | 4.92 Ω |
| | Lp | 1016.2 nH | 1045.75 nH | 1064.37 nH |
| Gütefaktor -modelliert | Cp₁ | 265 pF | 182pF | 119 pF |
| | Rp₁ | 770 Ω | 305 Ω | 116 Ω |
| | Cp₂ | 277 pF | 141 pF | 101 pF |
| | Rp₂ | 280 Ω | 250 Ω | 175 Ω |
| | RLp | 9.85 Ω | 7.31Q | 4.72 Ω |
| | Lp | 1010.37 nH | 1041.05 nH | 1051.3nH |
| | Qmax | 2.61 | 3.36 | 3.70 |

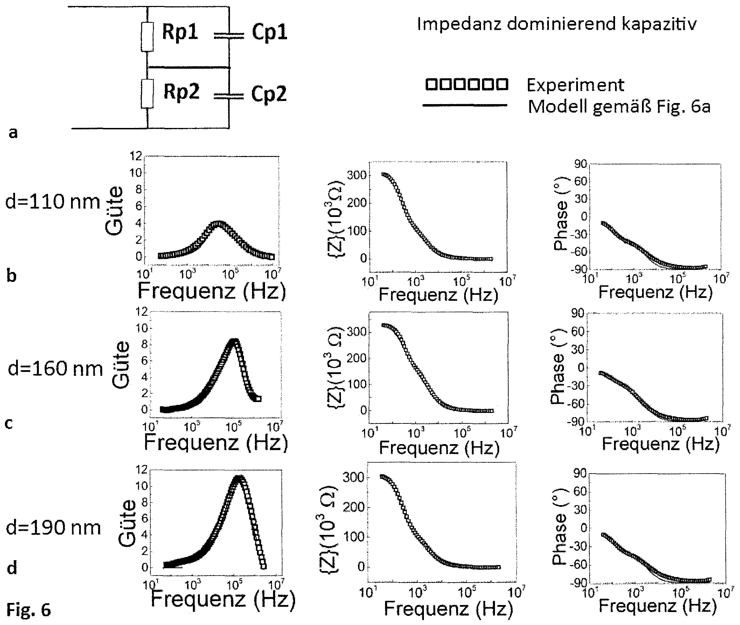

In Figur 6a ist ein Ersatzschaltbild des Materials mit geladenen Domänenwänden zur Modellierung der gemessenen komplexen Impedanz Z mit dominierend kapazitivem Blindwiderstand (Fig. 6a) abgebildet. Im Wesentlichen erfolgt die Modellierung durch zwei (Rp, Cp)-Paare (Rp₁, Cp₁ und Rp₂, Cp₂). Die Impedanz und der Gütefaktor wurden mit dem in Fig. 6a dargestellten Ersatzschaltbild modelliert. Die modellierten Werte der Parallel-Kapazität Cp₁ und Cp₂ nehmen mit der Dicke des Materials der mindestens einen Schicht ab. Die Parallelwiderstände Rp₁ und Rp₂ und der Gütefaktor Qₘₐₓ nehmen mit der Dicke des Materials zu. Die gemessenen und modellierten Gütefaktoren und Impedanzdaten sind für das Material mit einer Dicke von d = 110 nm (Fig. 6b), d = 160 nm (Fig. 6c) und d = 190 nm (Fig. 6d) gezeigt.

Die Tabelle 2 zeigt die modellierten Werte des Ersatzschaltbildes des Materials mit einer Dicke von d = 110 nm, 160 nm und 190 nm im HRS mit geladenen Domänenwänden, gemäß Figur 6.

**Tab.2: Modellierung der Impedanz und des Gütefaktors in Figur 6.**

| HRS | | YMO 110nm | YMO 160nm | YMO 190nm |
|---|---|---|---|---|
| Impedanz - modelliert | Cp₁ | 980 pF | 780 pF | 130 pF |
| | Rp₁ | 262500 Ω | 282500 Ω | 302500 Ω |
| | Cp₂ | 294 pF | 190 pF | 50 pF |
| | Rp₂ | 770 Ω | 1770 Ω | 2270 Ω |
| Gütefaktor - modelliert | Cp₁ | 540 pF | 200 pF | 140 pF |
| | Rp₁ | 265500 Ω | 310500 Ω | 350500 Ω |
| | Cp₂ | 100 pF | 50 pF | 10 pF |
| | Rp₂ | 550 Ω | 1000 Ω | 5400 Ω |
| | Qmax | 3.965 | 8.775 | 11.05 |

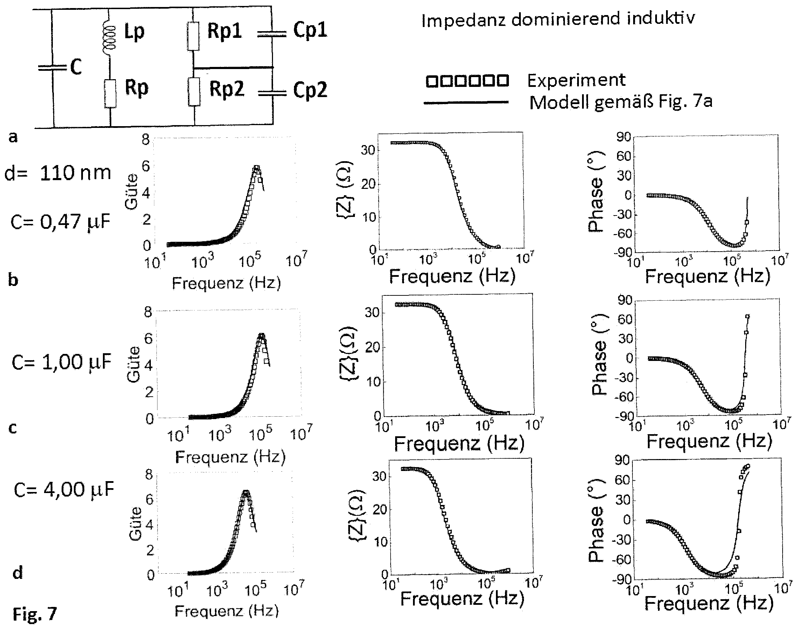

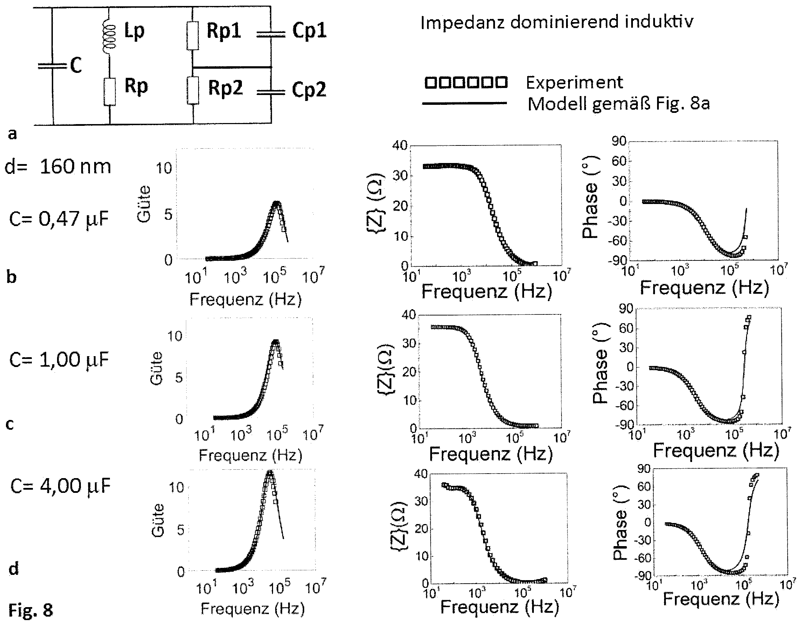

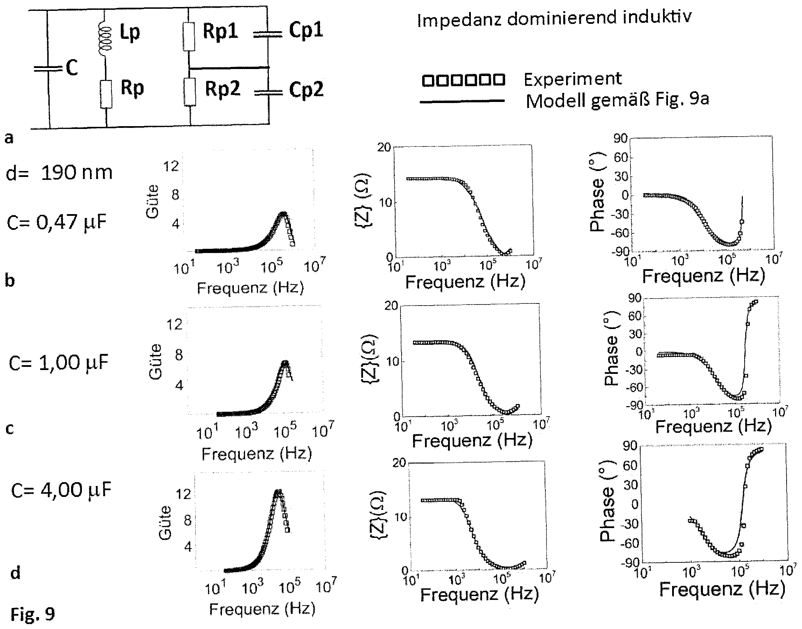

Der Gütefaktor und die Resonanzfrequenz werden durch parallel ergänzte diskrete elektronische Bauelemente kontrolliert eingestellt. Das wird gezeigt für das Material im LRS mit geladenen Domänenwänden mit einer Dicke von d = 110 nm (Fig. 7), d = 160 nm (Fig. 8) und d = 190 nm (Fig. 9) mit unterschiedlichen externen Kapazitäten C = 0,47 µF (Figuren 7b, 8b, 9b), C = 1,00 µF (Figuren 7c, 8c, 9c) und C = 4,00 µF (Figuren 7d, 8d, 9d). Die mit externer Kapazität C gemessenen Gütefaktoren und Impedanzdaten wurden für das Material mit Domänenwänden im LRS unter Verwendung der in (Figuren 7a, 8a, 9a) gezeigten Ersatzschaltbildern modelliert, wobei die externe Kapazität C mit ihrem nominellen Wert in die Modellierung einbezogen wurde.

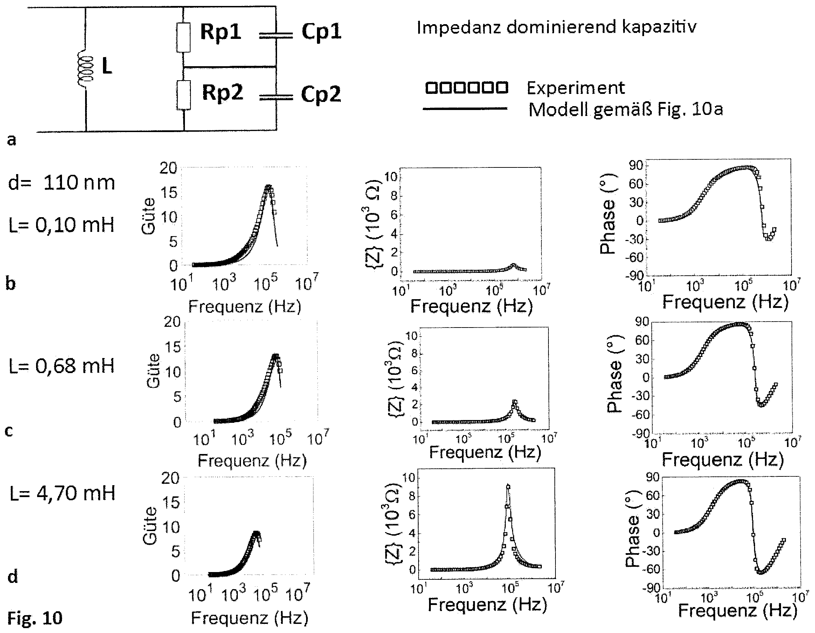

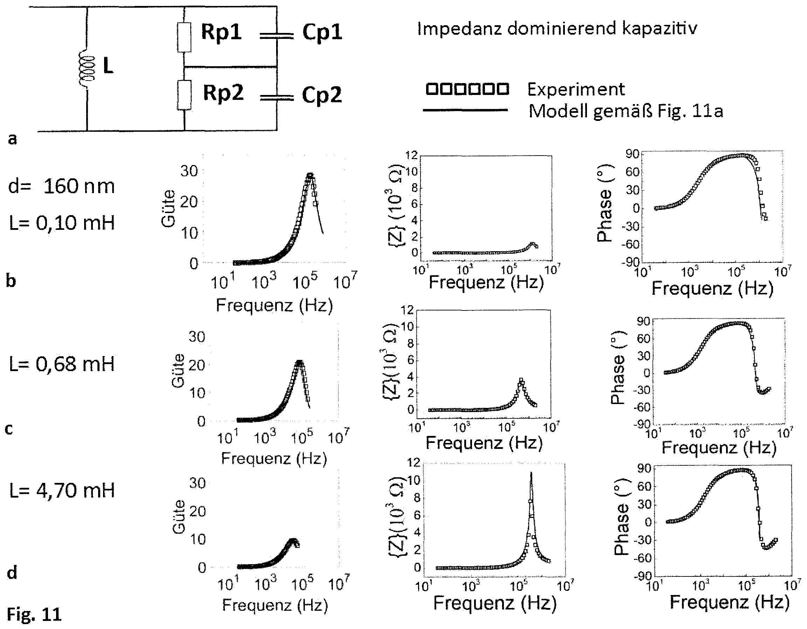

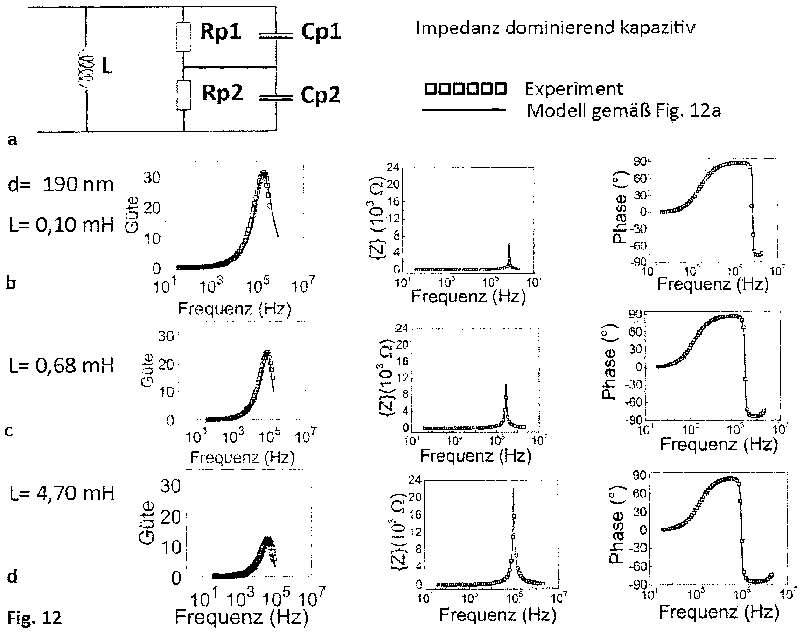

Das wird außerdem gezeigt für das Material im HRS mit geladenen Domänenwänden 5 mit einer Dicke von d = 110 nm (Fig. 10), d = 160 nm (Fig. 11) und d = 190 nm (Fig. 12) mit unterschiedlichen externen Induktivitäten L = 0,10 mH (Figuren 10b, 11b, 12b), L = 0,68 mH (Figuren 10c, 11c, 12c) und C = 4,00 mH (Figuren 10d, 11d, 12d). Die mit externer Induktivität L gemessenen Gütefaktoren und Impedanzdaten wurden für das Material mit Domänenwänden 5 im HRS unter Verwendung der in den Figuren 10a, 11a, 12a gezeigten Ersatzschaltbildern modelliert, wobei die externe Induktivität L mit ihrem nominellen Wert in die Modellierung einbezogen wurde.

### Bezugszeichenliste

- 1: nichtflüchtiger Impedanzschalter
- 2: erster Kontakt
- 3: zweiter Kontakt
- 4: geladene Domänenwände enthaltende Schichtabfolge, Seltene-Erd-Manganat
- 5: geladene Domänenwände
- 6: Substrat
- 7: Vortex
- 8: Isolationsstruktur
- 9: Heiz- und/oder Kühlelement
- d: Dicke der Schichtabfolge

## Patentansprüche

1. Verfahren zum Ausbilden eines Seltene-Erd-Manganats mit einer resultierenden Impedanz mit dominierend induktivem Blindwiderstand mittels Rekonfiguration einer Vortex (7)-Dichte, wobei ein einmaliges Spannungs-Zeit-Profil zwischen einem ersten (2) und einem zweiten (3), an das Seltene-Erd-Manganat angebrachten elektrisch leitenden Kontakt des Seltene-Erd-Manganats angelegt wird, so dass das Seltene-Erd-Manganat in einem Bereich eines sich zwischen den beiden elektrisch leitenden Kontakten ausbildenden elektrischen Feldes während eines Abkühlvorganges während und nach Anlegen des einmaligen Spannungs-Zeit-Profils eine Ordnungstemperatur durchläuft und damit die Vortex (7)-Dichte lokal im Bereich des sich zwischen den beiden elektrisch leitenden Kontakten ausbildenden elektrischen Feldes beeinflusst und eingestellt wird, **dadurch gekennzeichnet, dass** das Spannungs-Zeit-Profil ein Spannungsimpuls oder eine Spannungsrampe ist, wobei für die Rekonfiguration der Vortex (7)-Dichte ein Temperaturgradient größer als 1 K/min, bevorzugt größer als 10 K/min, noch bevorzugter größer als 100 K/min erzeugt wird, wobei der Temperaturgradient mittels des Spannungs-Zeit-Profils und durch Isolationsstrukturen (8), in welche das Seltene-Erd-Manganat eingebettet ist, beeinflusst und eingestellt wird.

2. Verfahren zum Ausbilden eines Seltene-Erd-Manganats mit einer resultierenden Impedanz mit dominierend kapazitivem Blindwiderstand mittels Rekonfiguration einer Vortex (7)-Dichte, wobei ein einmaliges Spannungs-Zeit-Profil zwischen einem ersten (2) und einem zweiten (3), an das Seltene-Erd-Manganat angebrachten elektrisch leitenden Kontakt des Seltene-Erd-Manganats angelegt wird, so dass das Seltene-Erd-Manganat in einem Bereich eines sich zwischen den beiden elektrisch leitenden Kontakten ausbildenden elektrischen Feldes während eines Abkühlvorganges während und nach Anlegen des einmaligen Spannungs-Zeit-Profils eine Ordnungstemperatur durchläuft und damit die Vortex (7)-Dichte lokal im Bereich des sich zwischen den beiden elektrisch leitenden Kontakten ausbildenden elektrischen Feldes beeinflusst und eingestellt wird, **dadurch gekennzeichnet, dass** das Spannungs-Zeit-Profil ein Spannungsimpuls oder eine Spannungsrampe ist, wobei für die Rekonfiguration der Vortex (7)-Dichte ein Temperaturgradient kleiner als 100 K/min, bevorzugt kleiner als 10 K/min, noch bevorzugter kleiner als 1 K/min erzeugt wird, wobei der Temperaturgradient mittels des Spannungs-Zeit-Profils und durch Isolationsstrukturen (8), in welche das Seltene-Erd-Manganat eingebettet ist, beeinflusst und eingestellt wird.

3. Ein nichtflüchtiger Impedanzschalter (1) rekonfiguriert nach dem Verfahren nach Anspruch 1 oder Anspruch 2 umfassend eine Schichtabfolge bestehend aus mindestens einer Schicht aus einem Seltene-Erd-Manganat (4) sowie einen ersten Kontakt (2), der auf einer Seite des Seltene-Erd-Manganats (4) angeordnet ist sowie einen zweiten Kontakt (3), der auf der gegenüberliegenden Seite des ersten Kontaktes (2) oder auf der gleichen Seite wie der erste Kontakt (2) angeordnet ist sowie Isolationsstrukturen (8) zur zeitlich gesteuerten Wärmeabfuhr und zur Einstellung eines Temperaturgradienten während eines Durchlaufens einer Ordnungstemperatur des Seltene-Erd-Manganats (4).

4. Der nichtflüchtige Impedanzschalter (1) nach Anspruch 3, wobei mindestens einer der beiden Kontakte (2, 3) strukturiert ausgebildet ist.

5. Der nichtflüchtige Impedanzschalter (1) nach Anspruch 3 oder 4, wobei das Seltene-Erd-Manganat (4) das Material hexagonales YMnOs ist.

6. Der nichtflüchtige Impedanzschalter (1) nach einem der Ansprüche 3 bis 5, wobei die Dicke der Schichtabfolge (4) größer als 5 nm und kleiner als 5000 nm ist.

7. Der nichtflüchtige Impedanzschalter (1) nach einem der Ansprüche 3 bis 6, wobei der erste Kontakt (2) und / oder zweite Kontakt (3) eine Fläche von 10¹ bis 10⁵ µm² aufweist, vorzugsweise eine Fläche von 10¹ bis 10³ µm² aufweist.

8. Verwendung des nichtflüchtigen Impedanzschalters (1) nach einem der vorherigen Ansprüche 3 bis 7 als diskretes Bauelement in einer elektronischen Schaltung zur Anpassung einer Phasenverschiebung.

9. Verwendung des nichtflüchtigen Impedanzschalters nach einem der vorherigen Ansprüche 3 bis 7 als durchstimmbares Filter.

10. Verwendung des nichtflüchtigen Impedanzschalters nach einem der vorherigen Ansprüche 3 bis 7 als Zwei-Pin-Bauelement für diskrete passive Bauelemente.

11. Verwendung des nichtflüchtigen Impedanzschalters nach einem der vorherigen Ansprüche 3 bis 7 als Flip-Chip zur Integration in Schaltungen für energieeffiziente Spannungswandler.

## Claims

1. A method of forming a rare earth manganate having a resultant impedance with dominant inductive reactance by reconfiguring a vortex (7) density, wherein a unique voltage-time profile is applied between a first (2) and a second (3) electrically conductive contact of the rare earth manganate attached to the rare earth manganate, so that the rare-earth manganate passes through an ordering temperature in a region of an electric field forming between the two electrically conductive contacts during a cooling process during and after application of the unique voltage-time profile and the vortex (7) density is thus influenced and adjusted locally in the region of the electric field forming between the two electrically conductive contacts, **characterized in that** the voltage-time profile is a voltage pulse or a voltage ramp, wherein a temperature gradient greater than 1 K/min, preferably greater than 10 K/min, even more preferably greater than 100 K/min, is generated for reconfiguring the vortex (7) density, wherein the temperature gradient is influenced and adjusted by means of the voltage-time profile and by insulation structures (8) in which the rare-earth manganate is embedded.

2. A method of forming a rare earth manganate having a resultant impedance with dominant capacitive reactance by reconfiguring a vortex (7) density, wherein a unique voltage-time profile is applied between a first (2) and a second (3) electrically conductive contact of the rare earth manganate attached to the rare earth manganate, so that the rare-earth manganate passes through an ordering temperature in a region of an electric field forming between the two electrically conductive contacts during a cooling process during and after application of the unique voltage-time profile and the vortex (7) density is thus influenced and adjusted locally in the region of the electric field forming between the two electrically conductive contacts, **characterized in that** the voltage-time profile is a voltage pulse or a voltage ramp, wherein a temperature gradient of less than 100 K/min, preferably less than 10 K/min, even more preferably less than 1 K/min, is generated for reconfiguring the vortex (7) density, wherein the temperature gradient is influenced and adjusted by means of the voltage-time profile and by insulation structures (8) in which the rare earth manganate is embedded.

3. A non-volatile impedance switch (1) reconfigured according to the method of claim 1 or claim 2 comprising a layer sequence consisting of at least one layer of a rare-earth manganate (4) and a first contact (2) arranged on one side of the rare-earth manganate (4) and a second contact (3) arranged on the opposite side of the first contact (2) or on the same side as the first contact (2) as well as insulation structures (8) for time-controlled heat dissipation and for setting a temperature gradient during a passage of an ordering temperature of the rare-earth manganate (4).

4. The non-volatile impedance switch (1) according to claim 3, wherein at least one of the two contacts (2, 3) is structured.

5. The non-volatile impedance switch (1) according to claim 3 or 4, wherein the rare earth manganate (4) is the material hexagonal YMnO₃ .

6. The non-volatile impedance switch (1) according to any one of claims 3 to 5, wherein the thickness of the layer sequence (4) is greater than 5 nm and less than 5000 nm.

7. The non-volatile impedance switch (1) according to any one of claims 3 to 6, wherein the first contact (2) and/or second contact (3) has an area of 10¹ to 10⁵ µm², preferably an area of 10¹ to 10³ µm².

8. Use of the non-volatile impedance switch (1) according to any one of the preceding claims 3 to 7 as a discrete component in an electronic circuit for adjusting a phase shift.

9. Use of the non-volatile impedance switch according to any one of the preceding claims 3 to 7 as a tunable filter.

10. Use of the non-volatile impedance switch according to any of the preceding claims 3 to 7 as a two-pin component for discrete passive components.

11. Use of the non-volatile impedance switch according to any one of the preceding claims 3 to 7 as a flip chip for integration into circuits for energy-efficient voltage converters.

## Revendications

1. Procédé de formation d'un manganate de terre rare ayant une impédance résultante avec une réactance inductive dominante par reconfiguration d'une densité de vortex (7), dans lequel un profil tension-temps unique est appliqué entre un premier (2) et un deuxième (3) contact électriquement conducteur du manganate de terre rare fixé au manganate de terre rare, de sorte que le manganate de terre rare passe par une température d'ordre dans une zone d'un champ électrique qui se forme entre les deux contacts électriquement conducteurs pendant un processus de refroidissement pendant et après l'application du profil tension-temps unique et que la densité du vortex (7) est ainsi influencée et réglée localement dans la zone du champ électrique qui se forme entre les deux contacts électriquement conducteurs, **caractérisé en ce que** le profil tension-temps est une impulsion de tension ou une rampe de tension et **en ce que** un gradient de température est supérieur à 1 K/min, de préférence supérieur à 10 K/min, de préférence encore supérieur à 100 K/min, le gradient de température étant influencé et réglé au moyen du profil tension-temps et par des structures d'isolation (8) dans lesquelles le manganate de terre rare est noyé.

2. Procédé de formation d'un manganate de terre rare ayant une impédance résultante avec une réactance capacitive dominante par reconfiguration d'une densité de vortex (7), dans lequel un profil tension-temps unique est appliqué entre un premier (2) et un deuxième (3) contact électriquement conducteur du manganate de terre rare fixé au manganate de terre rare, de sorte que le manganate de terre rare passe par une température d'ordre dans une zone d'un champ électrique qui se forme entre les deux contacts électriquement conducteurs pendant un processus de refroidissement pendant et après l'application du profil tension-temps unique et que la densité du vortex (7) est ainsi influencée et réglée localement dans la zone du champ électrique qui se forme entre les deux contacts électriquement conducteurs, **caractérisé en ce que** le profil tension-temps est une impulsion de tension ou une rampe de tension et **en ce que** un gradient de température est inférieur à 100 K/min, de préférence inférieur à 10 K/min, de préférence encore inférieur de 1 K/min, le gradient de température étant influencé et réglé au moyen du profil tension-temps et par des structures d'isolation (8) dans lesquelles le manganate de terre rare est noyé.

3. Un commutateur d'impédance non volatil (1) reconfiguré selon le procédé de la revendication 1 ou de la revendication 2 comprenant une séquence de couches composée d'au moins une couche d'un manganate de terre rare (4) ainsi qu'un premier contact (2) qui est disposé sur un côté du manganate de terre rare (4) ainsi qu'un deuxième contact (3), qui est disposé sur le côté opposé du premier contact (2) ou sur le même côté que le premier contact (2), ainsi que des structures d'isolation (8) pour l'évacuation de la chaleur commandée dans le temps et pour le réglage d'un gradient de température pendant un passage d'une température d'ordre du manganate de terres rares (4).

4. Le commutateur d'impédance non volatil (1) selon la revendication 3, dans lequel au moins l'un des deux contacts (2, 3) est structuré.

5. Le commutateur d'impédance non volatil (1) selon la revendication 3 ou 4, dans lequel le manganate de terre rare (4) est le matériel YMnO₃ hexagonal.

6. Le commutateur d'impédance non volatil (1) selon l'une des revendications 3 à 5, dans lequel l'épaisseur de la séquence de couches (4) est supérieure à 5 nm et inférieure à 5000 nm.

7. Le commutateur d'impédance non volatil (1) selon l'une des revendications 3 à 6, dans lequel le premier contact (2) et / ou le deuxième contact (3) présente une surface de 10¹ à 10⁵ µm², de préférence une surface de 10¹ à 10³ µm².

8. Utilisation du commutateur d'impédance non volatile (1) selon l'une des revendications précédentes 3 à 7 comme composant discret dans un circuit électronique pour adapter un déphasage.

9. Utilisation du commutateur d'impédance non volatile selon l'une des revendications précédentes 3 à 7 comme filtre accordable.

10. Utilisation du commutateur d'impédance non volatile selon l'une des revendications précédentes 3 à 7 comme composant à deux broches pour des composants passifs discrets.

11. Utilisation du commutateur d'impédance non volatile selon l'une des revendications précédentes 3 à 7 comme flip chip pour l'intégration dans des circuits pour des convertisseurs de tension à haute efficacité énergétique.
